# FASCICULE DE BREVET EUROPEEN

(11) **EP 0 487 380 B1**
(45) Date de publication et mention de la délivrance du brevet: **29.05.1996**
(21) Numéro de dépôt: 91403055.6
(22) Date de dépôt: 14.11.1991
(51) Int. Cl.: H01L 21/033, H01L 21/308, H01L 21/28

(54) **Procédé de gravure de couches de circuit intégré à profondeur fixée**
Verfahren zum Ätzen von Schichten mit vorgegebener Tiefe in integrierten Schaltungen
Process for etching layers at a given depth in integrated circuits

(30) Priorité: 16.11.1990 FR 9014306
(43) Date de publication de la demande: 27.05.1992
(73) Titulaire: FRANCE TELECOM, F-75015 Paris (FR)
(72) Inventeur: Haond, Michel, F-38240 Meylan (FR)
(74) Mandataire: Fréchède, Michel

(56) Documents cités:
- EP-A- 314 522
- US-A- 4 628 588
- US-A- 4 837 180
- PATENT ABSTRACTS OF JAPAN vol. 11, no. 77 (E-487)(2524) 7 Mars 1987 & JP-A-61 232 620 ( MATSUSHITA ELECTRONICS ) 16 Octobre 1986
- PATENT ABSTRACTS OF JAPAN vol. 9, no. 32 (C-265)(1755) 9 Février 1985 & JP-A-59 177 376 ( FUJITSU ) 8 Octobre 1984
- PATENT ABSTRACTS OF JAPAN vol. 12, no. 72 (E-588)5 Mars 1988 & JP-A-62 214 622 ( MITSUBISHI ELECTRIC ) 21 Septembre 1987

## Description

### PROCEDE DE GRAVURE DE COUCHES DE CIRCUIT INTEGRE A PROFONDEUR FIXEE

L'invention est relative à un procédé de gravure de couches de circuit intégré à profondeur fixée et au circuit intégré correspondant.

La fabrication d'un circuit intégré résulte d'un enchaînement d'étapes élémentaires telles que étapes de photolithographie, de gravure, d'implantation ionique et de traitement thermique par exemple.

Dans l'évolution des procédés pour la fabrication de circuits intégrés toujours plus denses et de dimensions de plus en plus réduites, la mise en oeuvre de chaque étape élémentaire devient plus délicate et nécessite une précision et une faculté de reproductibilité accrues.

Dans les procédés submicroniques, les gravures de motifs en temps fixe, c'est-à-dire les processus de gravure dans lesquels la profondeur de gravure est déterminée par le temps de mise en oeuvre du processus de gravure pour un matériau de nature déterminée, et pour un mode ou agent chimique de gravure donné compte tenu de ce matériau, se multiplient. Il en est ainsi, notamment, des gravures de tranchées d'isolement ou de la fabrication de grilles de silicium polycristallin dites en "T inversé".

Malgré toutes les précautions prises pour la mise en oeuvre des processus précités, ceux-ci ne peuvent prétendre atteindre les qualités de précision et de reproductibilité précédemment mentionnées, en particulier en raison de l'inadéquation de ce type de processus à la commutation ou passage de l'état de gravure à celui de non gravure, une telle commutation ne pouvant prétendre être instantanée, ce qui a pour effet d'introduire une zone d'incertitude, non nulle, de la profondeur effectivement atteinte par la gravure, aux risques d'hétérogénéité locale ou générale des caractéristiques physiques des matériaux à graver et donc de leurs vitesses de gravure d'un circuit intégré à l'autre, ces paramètres de gravure dépendant notoirement des conditions opératoires, même dans le cas de circuits intégrés de même type.

Le document Patent Abstracts of Japan, Vol. 11, n° 77 (E- 487) et JP-A- 61 232 620 décrit la formation d'une tranchée dans un substrat de silicium utilisant un masque de Si₃N₄ où l'érosion du masque pendant la gravure permet l'obtention d'une tranchée de profondeur déterminée.

La présente invention a pour objet de remédier aux inconvénients précités et notamment d'augmenter sensiblement la précision de la gravure des couches de circuit intégré dans le domaine submicronique.

Un autre objet de la présente invention est d'augmenter sensiblement la faculté de reproductibilité d'un circuit intégré à l'autre de même type.

Un autre objet de la présente invention est la mise en oeuvre d'un procédé de gravure d'une couche de matériau d'un circuit intégré à profondeur fixée et du circuit intégré correspondant.

Le procédé de gravure d'une couche de matériau d'un circuit intégré, couche à graver, sur profondeur fixée, objet de la présente invention, est tel que défini par les revendications 1 à 4.

Selon un premier mode de mise en oeuvre du procédé, object de la présente invention, on obtien un circuit intégré, qui est remarquable en ce qu'il comporte au moins, dans un substrat de matériau déterminé, une zone en créneau, la surface libre dudit substrat au voisinage de ladite zone en créneau comportant un revêtement d'une couche en matériau différent de celui du substrat.

Selon un deuxième mode de mise en oeuvre, du procédé objet de la présente invention, on obtient un circuit intégré, qui est remarquable en ce qu'il comporte, au moins sur un substrat de matériau déterminé, une zone en saillie, cette zone en saillie étant formée par un même matériau superposé sur la surface du substrat et présentant sensiblement la forme d'un T inversé.

Une description plus détaillée de l'objet de la présente invention sera maintenant donnée en liaison avec la description et avec les dessins ci-après dans lesquels :
- la figure 1 représente un schéma illustratif de mise en oeuvre du procédé objet de l'invention, de gravure à profondeur fixée,
- la figure 2 représente un schéma illustratif de mise en oeuvre du procédé objet de l'invention, plus particulièrement destiné à la réalisation d'éléments en forme de T inversé,
- la figure 3 représente une vue en coupe d'un circuit intégré dans lequel la gravure à profondeur fixée a été réalisée conformément au procédé objet de l'invention,
- la figure 4 représente une vue en coupe d'un circuit intégré dans lequel un élément en forme de T inversé a été réalisé conformément au procédé selon l'invention,
- la figure 5 représente une vue en coupe d'un circuit intégré dans lequel un élément a été réalisé au moyen d'une variante du procédé objet de l'invention tel qu'illustré en figure 2.

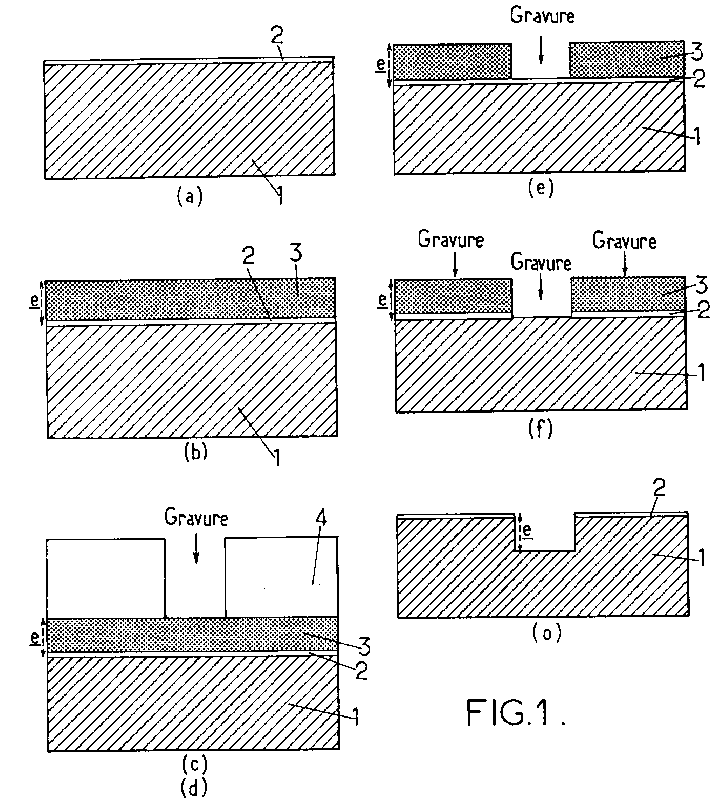

Le procédé de gravure d'une couche de matériau d'un circuit intégré à profondeur fixée, conformément à l'objet de la présente invention, sera tout d'abord décrit en liaison avec la figure 1. Selon la figure précitée, le procédé objet de l'invention consiste, ainsi que représenté au point a) de la figure 1, à déposer sur la couche de matériau constituant la couche à graver 1, une couche protectrice formant couche d'arrêt, notée 2.

Ensuite, ainsi qu'on l'a représenté au point b) de cette même figure 1, le procédé selon l'invention consiste à déposer, sur la couche d'arrêt 2, une couche dite couche de référence, notée 3, en matériau compatible avec celui de la couche à graver 1. Par matériau compatible avec celui de la couche à graver 1, on comprend tout type de matériau susceptible d'être gravé simultanément avec la couche à graver 1, dans des conditions opératoires proches ou identiques, ainsi qu'il sera décrit ultérieurement dans la description.

Selon un aspect particulier du procédé objet de l'invention, l'épaisseur de la couche de référence 3 est prise sensiblement proportionnelle à la profondeur de la gravure à réaliser dans la couche à graver 1. Bien entendu, ainsi qu'il sera décrit ultérieurement dans la description, on comprendra que le coefficient de proportionnalité reliant les valeurs des deux épaisseurs respectives de la couche de référence 3 et de la profondeur de la gravure à réaliser est déterminé en fonction des conditions opératoires des gravures respectives de ces couches.

Ainsi qu'on l'a en outre représenté aux points c) et d) de la figure 1, le procédé objet de l'invention consiste ensuite successivement à appliquer sur la couche de référence 3 un masque de gravure 4, aux dimensions planes de la gravure à effectuer dans la couche à graver 1, puis à effectuer la gravure de la couche de référence 3 par l'intermédiaire du masque de gravure 4 par attaque chimique, sèche ou humide, jusqu'à la rencontre de la couche d'arrêt 2. La rencontre de la couche d'arrêt s'entend de la rencontre, dans la zone de gravure, de la couche de référence 3.

Ainsi qu'on l'a ensuite montré au point e) de la figure 1, le procédé selon l'invention consiste alors à supprimer le masque de gravure 4 et la couche d'arrêt 2 dans la zone de gravure de la couche de référence 3. La suppression de la couche d'arrêt 2 peut être effectuée par attaque chimique, sèche ou humide.

Ensuite, ainsi que représenté au point f) de la figure 1, le procédé objet de la présente invention consiste alors à soumettre simultanément la couche de référence 3 et la couche de matériau à graver 1, au niveau de la zone libérée par la suppression de la couche d'arrêt 2 à l'étape précédente e), à une attaque chimique simultanée. L'attaque chimique simultanée de la couche de référence 3 et de la couche de matériau à graver 1 est poursuivie jusqu'à la rencontre de la couche d'arrêt 2, sous-jacente à la couche de référence 3, après disparition de cette dernière.

Au cours de l'opération effectuée au point f), telle qu'illustrée en figure 1, pour la mise en oeuvre du procédé objet de l'invention, la couche de référence 3 et la couche d'arrêt 2 forment un masque auxiliaire pour la couche à graver 1, de façon à créer dans la couche à graver 1 précitée une gravure aux dimensions planes de la gravure de la couche de référence 3 et de profondeur sensiblement proportionnelle à l'épaisseur de la couche de référence 3 précitée.

Sur cette même figure 1, au point o), on a représenté la couche gravée à profondeur fixée d'un circuit intégré obtenue par la mise en oeuvre du procédé, représenté selon les étapes a) à f) de cette même figure 1.

On comprendra bien sûr que les conditions opératoires de gravure et d'attaque chimique de la couche de référence 3 et de la couche à graver 1 peuvent alors être choisies de façon à obtenir une profondeur de gravure de la couche à graver 1 proportionnelle à l'épaisseur de la couche de référence 3, ceci par exemple en fixant les vitesses relatives de gravure de la couche de référence 3 et de la couche à graver 1 par un choix judicieux des agents de gravure et des conditions opératoires de ces agents de gravure.

Dans un mode de réalisation simplifiée du procédé objet de la présente invention, la couche de référence 3 peut avantageusement être constituée en un matériau identique à celui de la couche à graver 1. Dans ce cas, la couche de référence 3 présente alors une épaisseur e sensiblement égale à la profondeur de gravure à réaliser dans la couche à graver 1. Bien entendu, la gravure simultanée de la couche de référence 3 et de la couche à graver 1 est effectuée par l'intermédiaire des mêmes agents de gravure, dans des conditions opératoires sensiblement identiques.

Un deuxième mode de réalisation du procédé objet de l'invention sera décrit de manière avantageuse dans le cas où ce procédé est mis en oeuvre en vue de rapporter sur une couche de matériau d'un circuit intégré un élément en relief de hauteur déterminée. De manière générale, l'élément en relief de hauteur déterminée rapporté sur la couche de matériau d'un circuit intégré est un élément de type T inversé, selon la terminologie habituelle à ce type d'élément en relief dans le domaine technique de la réalisation des circuits intégrés.

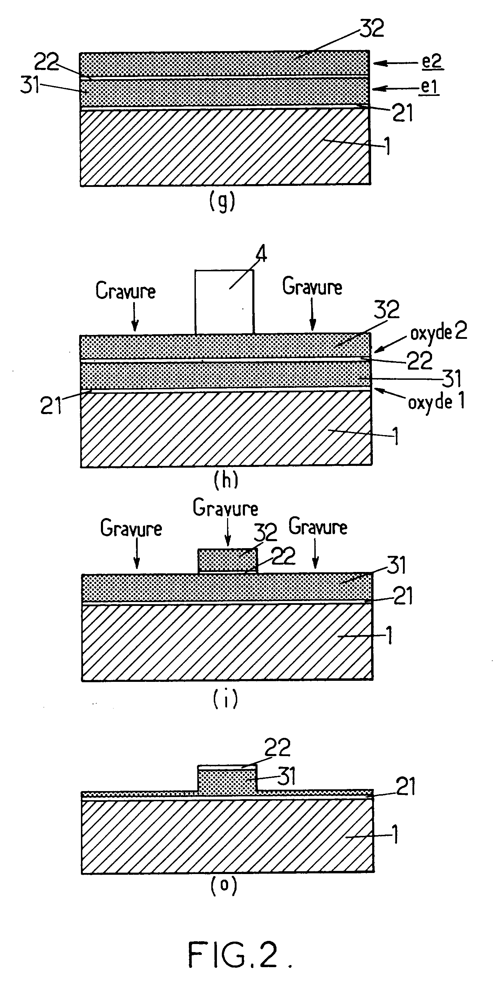

Ainsi qu'on l'a représenté en figure 2, le procédé objet de l'invention consiste alors, ainsi que représenté au point g), à répéter les étapes a) et b) précédemment décrites en liaison avec la figure 1 successivement, de façon à former sur la couche à graver 1 une couche 31 puis une surcouche 32 de référence. On notera que la couche 31 et la surcouche 32 de référence sont de préférence des couches de même nature et de même épaisseur. Aux couche 31 et surcouche 32 de référence sont associées, également par la répétition des étapes a) et b) précédentes, leurs couche 21 et surcouche d'arrêt 22 respectivement.

Le procédé objet de la présente invention, tel que représenté en figure 2, consiste ensuite au point h) à effectuer les étapes c), d) et e) précédemment décrites en relation avec la figure 1, relativement à la surcouche de référence 32 et à la surcouche d'arrêt 22, de façon à former, au niveau de la couche de référence 31, un élément en relief à rapporter, formant masque auxiliaire pour la couche de référence 31.

L'opération telle que représentée au point h) de la figure 2 est ensuite suivie, ainsi que représentée au point i) de cette même figure, d'une opération consistant alors à soumettre simultanément la couche de référence 31 et l'élément en relief de la surcouche de référence 32, formant masque auxiliaire, à une attaque chimique jusqu'à la rencontre de la couche d'arrêt 21, de façon à former au niveau de la couche de référence 31, l'élément en relief rapporté sur la couche de matériau à graver 1.

On comprendra bien entendu que le procédé objet de la présente invention, tant dans son premier mode de réalisation tel qu'illustré en figure 1 que dans son deuxième mode de réalisation tel qu'illustré en figure 2, peut être mis en oeuvre relativement a tout type ae matériau normalement utilisé pour la fabrication des circuits intégrés, et notamment pour des couches à graver 1 constituées par un matériau tel que l'oxyde de silicium SiO2, le nitrure de silicium Si3N4 ou le silicium Si mono ou polycristallin.

On notera en outre que, dans le cas de la mise en oeuvre du procédé objet de l'invention tel que représenté de manière illustrative en figure 2, la couche 31 et la surcouche 32 de référence peuvent être de même nature ou de nature différente.

Dans tous les cas de mise en oeuvre du procédé objet de l'invention, la dimension d'épaisseur de la couche de référence vis-à-vis de la couche à graver 1 ou de la surcouche de référence vis-à-vis de la couche de référence 31 est prise égale à une valeur proportionnelle à la dimension dans la même direction soit de la gravure à réaliser dans la couche à graver 1, soit respectivement de l'élément en T inversé à rapporter 31 sur la couche à graver 1. Le rapport de proportionnalité de ces dimensions est alors pris égal, pour des matériaux compatibles constituant la couche de référence 3 ou surcouche de référence 32, pour des modes ou agents chimiques de gravure appropriés respectifs de la couche de matériau à graver 1 et de la couche de référence 3 ou de la couche de référence 31 et de la surcouche de référence 32, au rapport des vitesses de gravure correspondantes.

On comprendra bien sur que lorsque la couche à graver 1 et la couche de référence 3, respectivement la couche de référence 31 et la surcouche de référence 32, sont en matériaux identiques, les dimensions d'épaisseur e sont alors sensiblement identiques. Les couche de référence et couche à graver 1 ou surcouche de référence 32 et couche de référence 31 sont alors soumises, en vue de leur gravure, aux mêmes modes ou agents chimiques de gravure.

On notera en particulier que, pour des matériaux constituant des couches à graver ou des couches ou surcouches de référence précédemment décrites, les agents chimiques de gravure peuvent être choisis parmi le groupe ci-après :

| Matériaux (1) et/ou (3) | Gaz de gravure sèche | Liquide |
|---|---|---|
| Si monocristallin | CF₄ - Cl₂ | KOH |
| Si pollycristallin | SF₆ - Cl₂ | HF - HNO₃ |
| Si amorphe | HCl - Cl₂ | |
| Nitrure de silicium | HCl - Cl₂ | |
| SiO₂ thermique | C₂F₆ - CHF₃ | HF |
| SiO₂ déposé | SF₆ - CHF₃ | HF dilués ou tamponnés |

En outre, on indique que l'agent chimique peut être constitué par un mélange de SF₆ ou C₂F₆ avec CHF₃ dans des proportions déterminées. Les modes ou agents chimiques de gravure peuvent comprendre CF₄ et 0₂.

En ce qui concerne la mise en oeuvre pratique du procédé objet de l'invention telle que représentée en figure 1, celle-ci peut être mise en oeuvre dans les conditions ci-après.

Le dépôt de la couche de référence 3 sur la couche d'arrêt 2 peut avantageusement être effectué, dans le cas où la couche à graver 1 est une couche de silicium, par le dépôt sur la couche d'arrêt 2 d'une épaisseur de silicium légèrement inférieure mais voisine de la profondeur de la gravure ou tranchée à effectuer, pour constituer la couche de référence 3. Le dépôt du masque de gravure 4, tel que représenté aux points c) et d) de cette même figure 1, peut alors être effectué par dépôt sur la couche de référence 3 d'une résine dans laquelle on pratique, par un procédé photolithographique par exemple, une ouverture aux dimensions planes de la gravure à réaliser.

La gravure de la couche de référence 3, telle que représentée à l'étape e) de la figure 1, peut alors être effectuée au moyen d'un procédé de gravure anisotrope, en utilisant la couche d'arrêt 2, constituée par exemple par une couche d'oxyde de silicium, comme couche d'arrêt avec détection de fin d'attaque. Le masque de résine 4 peut alors être ou non retiré.

La couche d'arrêt 2 peut alors être attaquée au niveau de l'ouverture ou zone pratiquée dans la couche de référence 3, en utilisant soit le masque de résine 4 sur couche de référence 3, soit la couche de référence 3 seule comme masque.

Le retrait de la résine formant le masque de gravure 4 ayant été effectué, si ce dernier était encore présent, la gravure simultanée de la couche de référence 3 et de la couche à graver 1 est effectuée, ainsi que représentée au point f) de la figure 1, à l'aide d'un procédé de gravure anisotrope. On comprend bien sûr que la gravure simultanée de la couche de référence 3 et de la couche à graver 1 est alors poursuivie, jusqu'à la rencontre de la couche d'arrêt 2 sous-jacente à la couche de référence 3, ce qui permet, par détection de fin d'attaque sur rencontre de cette couche d'arrêt 2, d'arrêter également la gravure de la couche à graver 1.

On comprendra bien sûr qu'une légère surgravure peut être effectuée pour être certain d'avoir parfaitement dégagé la couche de référence 3 sur la couche d'arrêt 2. Ainsi, la profondeur de la gravure sur la couche à graver 1 est égale à l'épaisseur de la couche de référence 3 déposée initialement plus une légère portion correspondant à la surgravure précédemment citée, cette surgravure étant bien entendu aisément calibrable et correspondant en général à un temps très court devant le temps de gravure total.

Conformément au mode de réalisation tel que représenté en figure 2 du procédé objet de l'invention, dans le cas de la réalisation d'éléments en relief de type T inversé, les étapes a) et b) du procédé tel qu'illustré en figure 1 sont répétées successivement, de façon à déposer sur la couche dite couche à graver, bien que celle-ci ne soit pas gravée en tant que telle, une couche de référence notée 31 et une surcouche de référence notée 32, ainsi que leurs couches d'arrêt respectives 21 et 22. De préférence, lorsque la couche de référence 31 et la surcouche de référence 32 sont constituées par un même matériau tel que du silicium, la couche de référence 31 peut présenter une épaisseur e1 et la surcouche de référence 32 une épaisseur e2, différente de e1. L'épaisseur e2 est alors inférieure mais voisine de la hauteur désirée pour la partie verticale du T inversé, constituant en fait une marche rapportée sur la couche à graver 1.

Puis, conformément au point h) de la figure 2, un masque de gravure 4, constitué par une résine, est appliqué, ce masque étant façonné par un procédé photolithographique de façon à maintenir le masque 4 au niveau des surfaces correspondant au sommet des marches, c'est-à-dire à la partie verticale du T inversé.

Ainsi qu'on l'a représenté au point i) de la figure 2, la surcouche de référence 32 est alors soumise à un processus de gravure en présence du masque 4, jusqu'à l'atteinte de la surcouche d'arrêt 22, avec détection de fin d'attaque et arrêt du processus de gravure de la surcouche 32. La gravure précitée est bien entendu effectuée au moyen d'une gravure anisotrope. Le masque de résine 4 peut alors ou non être retiré.

L'ensemble tel que représenté au point i) de la figure 2 est alors, en présence ou non du masque de gravure 4, soumis à un processus de gravure, de façon à effectuer la gravure simultanée de la couche de référence 31 et de l'élément en relief 32 résultant de la gravure antérieure. Dans cette opération, l'élément en relief 32 sert de masque auxiliaire pour la gravure de la couche de référence 31 et la formation de l'élément vertical au sommet de la marche en T inversé 31, tel que représenté au point o) de la figure 2, après la mise en oeuvre des étapes g), h), i) du procédé objet de l'invention, dans son deuxième mode de réalisation. On comprendra bien sûr que la gravure est finalement arrêtée par détection de fin d'attaque sur la surcouche d'arrêt 22, lorsque tout le silicium de la surcouche de référence 32 a été enlevé.

Bien entendu, une légère surgravure est toujours nécessaire afin d'être certain d'avoir bien dégagé le silicium sur la surcouche d'arrêt 22.

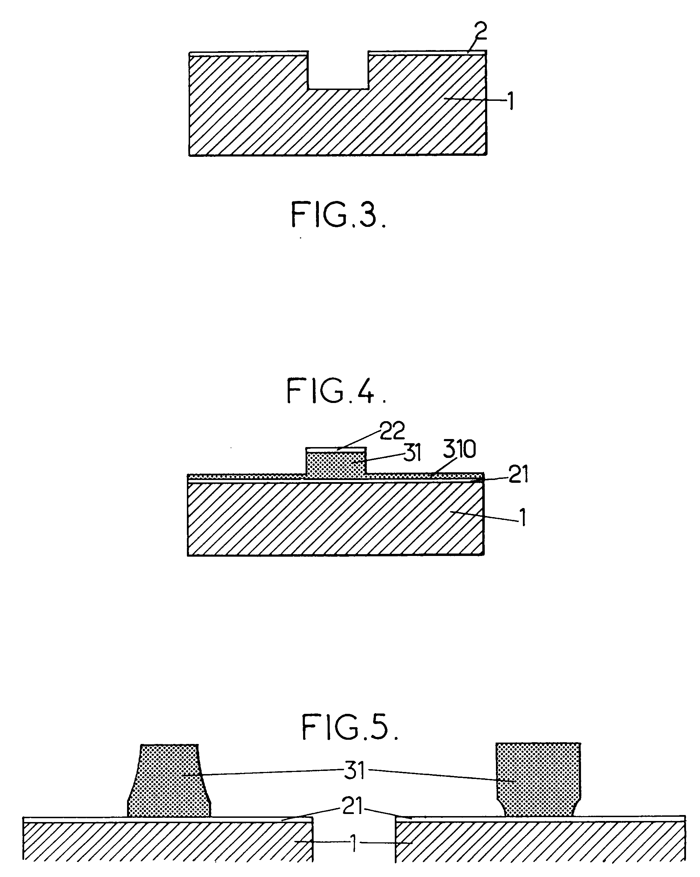

Une description plus détaillée d'un circuit intégré comportant au moins une couche gravée conformément à l'un ou l'autre des modes de réalisation du procédé objet de l'invention, tels que décrits en liaison avec les figures 1 et 2 précédentes, sera maintenant donnée en liaison avec les figures 3 respectivement 4.

Selon la figure 3, le circuit intégré obtenu suite à la mise en oeuvre du procédé objet de l'invention tel qu'illustré en figure 1, comporte au moins dans un substrat 1 de matériau déterminé, une zone en créneau. La surface libre du substrat, au voisinage de la zone en créneau, comporte un revêtement d'une couche 2 en matériau différent de celui du substrat, formant couche d'arrêt. Dans un exemple de réalisation, le substrat 1 constituant couche à graver sera constitué par du silicium et la couche d'arrêt sera constituée par de l'oxyde de silicium SiO2.

En outre, ainsi que représenté en figure 4, le circuit intégré obtenu par la mise en oeuvre du procédé tel qu'illustré en figure 2 comporte, au moins sur un substrat 1 de matériau déterminé, une zone en saillie 31, cette zone en saillie étant formée par un même matériau superposé sur la surface du substrat 1, et présentant sensiblement la forme d'un T inversé. Le plus souvent, le substrat 1 en matériau déterminé est constitué par du silicium Si, l'élément en saillie en forme de T inversé étant constitué par ce même matériau.

Ainsi qu'on l'a représenté en figure 4, la zone en saillie 31 est prise entre sa partie distale et sa partie de base entre deux couches 21 - 22 d'un même matériau, différent de celui du substrat et formant couche d'arrêt. Le plus souvent, les couches 21 - 22 sont réalisées en oxyde de silicium SiO2, alors que le substrat 1 est lui-même réalisé en silicium Si.

Ainsi qu'on l'a en outre représenté en figure 4, l'épaisseur de la couche 22 recouvrant la partie distale de la zone en saillie en forme de T inversé est sensiblement égale à celle de la partie 310 formant base de la zone en saillie.

Le mode de réalisation du procédé objet de l'invention tel que représenté en figure 2 n'est pas limité à la réalisation d'éléments strictement en forme de T inversé. En effet, le procédé précité permet de graver une épaisseur totale en deux temps :
- démarrage du processus de gravure par une attaque chimique, puis
- poursuite, après détection de la couche d'arrêt 22 avec une attaque chimique d'une autre nature.

Une telle variante du procédé précité permet alors de réaliser une forme finale différente de celle d'un T inversé au sens strict, les bords de gravure pouvant être totalement ou partiellement obliques ou incurvés ainsi que représenté en figure 5.

On a ainsi décrit un procédé de gravure à profondeur fixée dans lequel, grâce au rajout d'une couche de référence sur une couche d'arrêt, la couche de référence étant en un matériau proche du point de vue de la gravure du matériau constituant la couche à graver, on transforme une gravure en temps fixe en une gravure à profondeur fixée.

On notera que le procédé objet de l'invention, dans son premier et dans son deuxième mode de réalisation, rend totalement reproductible la gravure entre plaquettes de circuit intégré d'un même lot. Cette gravure devient également insensible à une dérive de procédé ou à un changement de machine, pourvu que la couche de référence, voire la surcouche de référence, aient les mêmes propriétés de gravure que la couche à graver. Une telle insensibilité s'explique comme suit: si la gravure ralentit, il en est de même pour les couches à graver, c'est-à-dire la couche de référence et la couche à graver effective. De ce fait, l'épaisseur gravée finale dans la couche à graver est la même. Toutefois, le procédé objet de la présente invention reste sensible aux inhomogénéités de gravure qui sont liées au procédé de gravure lui-même, ces inhomogénéités ne pouvant en elles-mêmes être évitées. On notera toutefois que l'introduction d'un léger temps de surgravure permet d'être certain que la gravure de la couche de référence ou de la surcouche de référence a bien été achevée.

## Revendications

1. Procédé de gravure d'une couche de matériau d'un circuit intégré, couche à graver, sur profondeur fixée, consistant :
a) à déposer sur ladite couche de matériau, couche à graver (1), une couche protectrice (2) formant couche d'arrêt et de détection de fin de gravure,
b) à déposer sur ladite couche d'arrêt une couche de référence (3) en matériau identique à celui de la couche à graver (1) et dont l'épaisseur est prise sensiblement égale à la profondeur de la gravure à réaliser dans ladite couche à graver,
c) à appliquer sur ladite couche de référence un masque (4) de gravure aux dimensions planes de la gravure à effectuer dans ladite couche à graver,
d) à effectuer la gravure de ladite couche de référence (3) par l'intermédiaire du masque de gravure par attaque chimique sèche, jusqu'à la rencontre de la couche d'arrêt dans la zone de gravure de la couche de référence,
e) à supprimer ledit masque (4) et ladite couche d'arrêt (2) dans la zone de gravure de ladite couche de référence (3),
f) à soumettre simultanément la couche de référence (3) et la couche de matériau à graver (1) à une même attaque chimique sèche, jusqu'à la rencontre de la couche d'arrêt (2), laquelle sert à signaler la fin de gravure, la couche de référence (3) et la couche d'arrêt formant un masque auxiliaire pour la couche à graver (1), de façon à créer, dans la couche à graver (1), une gravure aux dimensions planes de la gravure de la couche de référence (3) et de profondeur sensiblement égale à l'épaisseur de cette couche de référence (3).

2. Procédé selon la revendication 1, caractérisé en ce que, en vue de rapporter sur une couche de matériau d'un circuit intégré un élément en relief de hauteur déterminée, ledit procédé consiste :
g) à répéter les étapes a) et b) successivement de façon à former, sur ladite couche à graver, une couche (31) puis une surcouche (32) de référence de même nature et de même épaisseur et leur couche (21) et surcouche d'arrêt (22), respectivement,
h) à effectuer les étapes c), d) et e) relativement à la surcouche de référence (32) et à la surcouche d'arrêt (22), de façon à former, au niveau de la couche de référence (31), un élément en relief formant masque auxiliaire pour la couche de référence (31),
i) à soumettre simultanément la couche de référence (31) et l'élément relief de la surcouche de référence (32) formant masque auxiliaire à une même attaque chimique jusquà la rencontre de la couche d'arrêt (21), de façon à former au niveau de la couche de référence (31) ledit élément en relief rapporté sur ladite couche de matériau (1).

3. Procédé selon l'une des revendications 1 à 2, caractérisé en ce que la couche à graver est constituée par un matériau inclus dans le groupe SiO2, Si3N4, Si.

4. Procédé selon l'une des revendications précédentes, caractérisé en ce que les modes ou agents chimiques de gravure sont choisis parmi les agents SF6, C2F6, HCl, C12, CHF3, CF4, O2.

## Patentansprüche

1. Verfahren zum Ätzen einer Materialschicht - der zu ätzenden Schicht - einer integrierten Schaltung auf eine festgelegte Tiefe, umfassend:
a) Ablagern einer Schutzschicht (2) auf der Materialschicht, der zu ätzenden Schicht (1), wobei die Schutzschicht (2) eine Ätzstoppschicht und eine Schicht zur Detektion des Ätzendes bildet,
b) Ablagern einer Referenzschicht (3) auf der Stoppschicht, wobei die Referenzschicht (3) aus einem Material besteht, das identisch mit dem Material der zu ätzenden Schicht (1) ist und deren Dicke im wesentlichen gleich der Tiefe der in der zu ätzenden Schicht durchzuführenden Ätzung ist,
c) Aufbringen einer Ätzmaske (4) auf die Referenzschicht, wobei die Ätzmaske (4) die Flächenabmessungen der in der zu ätzenden Schicht durchzuführenden Ätzung aufweist,
d) Durchführen des Ätzens der Referenzschicht (3) mittels der Ätzmaske durch trockenchemisches Ätzen, bis zum Erreichen der Stoppschicht in der Ätz-Zone der Referenzschicht,
e) Entfernen der Maske (4) sowie der Stoppschicht (2) in der Atz-Zone der Referenzschicht (3),
f) Gleichzeitiges Unterziehen der Referenzschicht (3) und der zu ätzenden Materialschicht (1) einem gleichen trockenchemischen Ätzen, bis zum Erreichen der Stoppschicht (2), welche zum Anzeigen des Ätzendes dient, wobei die Referenzschicht (3) und die Stoppschicht für die zu ätzende Schicht (1) derart eine zusätzliche Maske bilden, daß in der zu ätzenden Schicht (1) eine Ätzung mit den Flächenabmessungen der Ätzung der Referenzschicht (3) und einer Tiefe gebildet wird, welche im wesentlichen gleich der Dicke der Referenzschicht (3) ist.

2. Verfahren nach Anspruch 1, dadurch gekennzeichnet, daß - um auf einer Materialschicht einer integrierten Schaltung ein erhabenes Element mit festgelegter Höhe zu erhalten - das Verfahren umfaßt:
g) Wiederholen der Schritte a) und b) nacheinander derart, daß auf der zu ätzenden Schicht gebildet wird:
eine Referenzschicht (31),
darauf eine Referenzüberschicht (32) mit der gleichen Beschaffenheit und der gleichen Dicke, sowie ihre Stoppschicht (21) bzw. Stoppüberschicht (22),
h) Durchführen der Schritte c), d) und e) an der Referenzüberschicht (32) und der Stoppüberschicht (22) derart, daß ein erhabenes Element im Bereich der Referenzschicht (31) gebildet wird, das eine zusätzliche Maske für die Referenzschicht (31) bildet,
i) Gleichzeitiges Unterziehen der Referenzschicht (31) und des erhabenen Elements der Referenzüberschicht (32), das eine zusätzliche Maske bildet, einem gleichen chemischen Ätzen, bis zum Erreichen der Stoppschicht (21) derart, daß das erhabene - auf die Materialschicht (1) aufgesetzte - Element im Bereich der Referenzschicht (31) gebildet wird.

3. Verfahren nach einem der Ansprüche 1 oder 2, dadurch gekennzeichnet, daß die zu ätzende Schicht aus einem Material gebildet wird, das in der Gruppe SiO2, Si3N4, Si enthalten ist.

4. Verfahren nach einem der vorhergehenden Ansprüche, dadurch gekennzeichnet, daß die Ätz-Zusammensetzungen oder chemischen Ätzmittel aus den Mitteln SF6, C2F6, HCl, C12, CHF3, CF4, O2 gewählt sind.

## Claims

1. A method for etching a layer of material of an integrated circuit, the layer to be etched, over a fixed depth, said method consisting:
a) in depositing onto said layer of material, the layer to be etched (1), a protective layer (2) forming a stop and an end of etching detecting layer,
b) in depositing onto said stop layer a reference layer (3) made of a material identical to that of the layer to be etched (1) and whose thickness is made substantially equal to the depth of the etch to be produced in said layer to be etched,
c) in applying to said reference layer an etch mask (4) having the plane dimensions of the etch to be produced in said layer to be etched,
d) in carrying out the etching by chemical attack, dry or wet, of said reference layer (3) by means of the etch mask until encountering the stop layer in the zone for etching of the reference layer (3),
e) in removing said mask (4) and said stop layer (2) in the zone for etching of said reference layer (3),
f) in simultaneously subjecting the reference layer (3) and the layer of material to be etched (1) to a dry chemical attack until encountering the stop layer (2) which indicates thus the end of etching operation, the reference layer (3) and the stop layer forming an auxiliary mask for the layer to be etched (1) so as to create, in the layer (1) to be etched, an etch having the plane dimensions of the etch of the reference layer (3) and a depth substantially equal to the thickness of this reference layer (3).

2. The method as claimed in claim 1, which, with a view to adding onto a layer of material of an integrated circuit a raised element of specified height, consists:
g) in successively repeating the steps a) and b) so as to form, on said layer to be etched, a reference layer (31) and then an upper reference layer (32) of the same type and of the same thickness, and their stop layer (21) and upper stop layer (22), respectively,
h) in carrying out the steps c), d) and e) relating to the upper reference layer (32) and to the upper stop layer (22) so as to form, in the region of the reference layer (31), a raised element to be added which forms an auxiliary mask for the reference layer (31),
i) in simultaneously subjecting the reference layer (31) and the raised element of the upper reference layer (32) forming an auxiliary mask to a chemical attack until encountering the stop layer (21) so as to form, in the region of the reference layer (31), said raised element added onto said layer of material (1).

3. The method as claimed in one of claims 1 to 2, wherein the layer to be etched is constituted by a material included in the group SiO₂, S1₃N₄, Si.

4. The method as claimed in either of claims 1 and 4, wherein the etch modes or etchants are chosen from among the agents SF₆, C₂F₆, HC1, Cl₂, CHF₃, CF₄, O₂.
